(19) Europäisches Patentamt

**European Patent Office**

**Office européen des brevets**

(11) Numéro de publication: **0 297 933 B1**

(12) **FASCICULE DE BREVET EUROPEEN**

(45) Date de publication de fascicule du brevet: **04.08.93** (51) Int. Cl.⁵: **G01R 27/18**

(21) Numéro de dépôt: **88401152.9**

(22) Date de dépôt: **11.05.88**

(54) **Dispositif de contrôle et de mesure de l'isolement d'un réseau électrique.**

(30) Priorité: **04.06.87 FR 8707871**

(43) Date de publication de la demande:
**04.01.89 Bulletin 89/01**

(45) Mention de la délivrance du brevet:
**04.08.93 Bulletin 93/31**

(84) Etats contractants désignés:
**AT BE CH DE ES GB IT LI NL SE**

(56) Documents cités:
EP-A- 0 033 858       EP-A- 0 083 306
DE-B- 2 542 811       FR-A- 1 586 914
GB-A- 2 191 591       US-A- 3 976 987
US-A- 4 200 835       US-A- 4 206 398
US-A- 4 335 348

(73) Titulaire: **MERLIN GERIN**
**Rue Henri Tarze**
**F-38050 Grenoble Cédex(FR)**

(72) Inventeur: **Le Maitre, Philippe**
**MERLIN GERIN Sce. Brevets**
**F-38050 Grenoble Cédex(FR)**
Inventeur: **Schuster, Philippe**
**MERLIN GERIN Sce. Brevets**
**F-38050 Grenoble Cédex(FR)**
Inventeur: **Pellegrin, Christian**
**MERLIN GERIN Sce. Brevets**
**F-38050 Grenoble Cédex(FR)**

(74) Mandataire: **Hecke, Gérard et al**
**Merlin Gérin, Sce. Propriété Industrielle**
**F-38050 Grenoble Cédex 9 (FR)**

# Description

L'invention est relative à un dispositif de contrôle et de mesure de l'isolement d'un réseau électrique par rapport à la terre, comprenant un circuit d'injection d'un signal alternatif de référence dans le réseau à surveiller, et un circuit électronique de détection destiné à fournir un signal de mesure significatif de l'état d'isolement du réseau en réponse à l'émission du signal de référence, ledit signal de mesure étant proportionnel à l'impédance d'isolement Z formée par une résistance de fuite Rf, et un condensateur C parasite dont la capacité dépend des caractéristiques du réseau, le circuit de détection comportant des moyens de discrimination des composantes dudit signal de mesure, ayant une première composante fonction du courant IR traversant la résistance de fuite Rf, et une deuxième composante fonction du courant IC circulant dans le condensateur C parasite, la fréquence du signal alternatif de référence injecté dans le réseau étant inférieure à la fréquence du réseau.

Selon un dispositif connu de l'art antérieur, un générateur peut injecter une tension alternative de référence à basse fréquence sur le réseau par l'intermédiaire d'un filtre. Le courant de fuite circulant dans le circuit en boucle par la terre est mesuré aux bornes d'une résistance de mesure. La tension aux bornes de la résistance de mesure constitue en fait l'image de la somme du premier courant partiel à travers la résistance de fuite Rf, et du deuxième courant partiel à travers la capacité parasite du réseau. La mesure directe de l'isolement aux bornes de la résistance de mesure donne par conséquent une indication erronée de l'état d'isolement du réseau. Un circuit auxiliaire de compensation permet dans certains cas de tenir compte de l'influence de la capacité parasite du réseau, mais la correction de la mesure suppose la connaissance à priori de la valeur de cette capacité. Il est difficile de connaître avec précision la valeur de cette capacité parasite qui varie beaucoup avec la configuration du réseau à surveiller, notamment en fonction du nombre de départs en service. La mesure de la tension aux bornes de la résistance de mesure est d'autre part souvent perturbée par des parasites engendrés par rayonnement ou conduction dans une gamme de fréquences très large. Ce principe connu de contrôle d'isolement peut exclusivement être appliqué à un réseau à neutre isolé.

Il est également connu, selon le document FR 1.586.914, de mesurer l'isolement d'un réseau par injection d'un courant de fréquence inférieure à celle du réseau, et de distinguer le courant traversant respectivement la résistance et la capacité d'isolement. Les circuits électroniques de détection restent toutefois compliqués et se trouvent sous l'influence de parasites pouvant donner une indication erronée de l'état d'isolement.

Selon le document US-A-3.976.987, un dispositif de surveillance d'isolement d'un réseau non relié à la terre comporte un circuit d'injection de signal de référence ayant une fréquence supérieure à celle du réseau. Il en résulte une capacitance importante du condensateur parasite qui affecte la précision et la fiabilité de la mesure.

Selon le document DE-A-2.542.811, un dispositif de contrôle d'isolement comporte un générateur d'injection d'un signal alternatif de référence, une résistance de mesure, et un circuit de détection synchrone de la résistance d'isolement avec élimination de la capacité parasite.

Ce dispositif n'a pas de filtre à la frequence du signal alternatif de référence, lequel signal est dans la gamme 25 - 500 Hz.

L'objet de l'invention consiste à réaliser un dispositif de contrôle et de mesure de l'isolement protégé des parasites, et capable de donner une indication fiable de l'état d'isolement du réseau indépendamment du régime de neutre choisi, et de la capacité parasite du réseau.

Le dispositif de contrôle et de mesure de l'isolement selon l'invention est caractérisé en ce que:

- les moyens de discrimination du circuit de détection comportent un dispositif détecteur synchrone ayant une paire d'inverseurs statiques de traitement des première et deuxième composantes du signal de mesure, et un convertisseur destiné à délivrer deux signaux C1 et C2 en quadrature pour la commande respective des inverseurs, le premier signal de commande C1 étant en phase avec le signal alternatif de référence injecté dans le réseau par le circuit d'injection,
- le signal de mesure proportionnel à l'impédance d'isolement Z est appliqué à un circuit de filtrage destiné à délivrer un signal filtré à la fréquence du signal alternatif de référence,
- un circuit amplificateur coopère avec le circuit de filtrage pour fournir deux signaux amplifiés S1 et S2 en opposition de phase, appliqués respectivement à un contact repos et à un contact travail de chaque inverseur,
- un circuit intégrateur est connecté à la sortie de chaque inverseur pour extraire la valeur moyenne des première et deuxième composantes du signal de mesure,
- et des moyens de calcul et d'affichage sont connectés à la sortie de chaque circuit intégrateur pour indiquer les valeurs de la résistances de fuite et de la capacité du condensateur C parasite.

La double détection synchrone est ainsi capable de décomposer le signal image de l'impédance d'isolement Z en deux composantes perpendiculaires:

- l'une IZ cos a étant alignée avec la tension de référence pour le calcul de la résistance de fuite Rf.
- l'autre IZ sin a en quadrature avec la première pour le calcul de la capacité parasite.

La sortie de chaque inverseur est connectée à un circuit intégrateur susceptible d'extraire la valeur moyenne des première et deuxième composantes du signal de mesure.

Selon un premier mode de réalisation du dispositif de contrôle appliqué à un réseau électrique à régime de neutre IT, le signal alternatif de référence est injecté dans le réseau au moyen d'un générateur par l'intermédiaire de condensateurs de liaison. Le signal de mesure est prélevé aux bornes d'une résistance de mesure insérée en série avec le générateur et l'impédance d'isolement.

Selon un deuxième mode de réalisation du dispositif de contrôle appliqué à un réseau électrique à régime de neutre TN ou TT, le signal alternatif de référence est injecté dans le réseau au moyen d'un premier tore d'excitation entourant les conducteurs R,S,T de phase du réseau et ayant un enroulement primaire raccordé à un générateur. Le signal de mesure représentant l'image de l'impédance d'isolement Z du réseau est prélevé aux bornes d'un enroulement secondaire bobiné sur un deuxième tore de mesure entourant les mêmes conducteurs du réseau.

D'autres avantages et caractéristiques ressortiront plus clairement de la description qui va suivre de différents modes de mise en oeuvre de l'invention donnés à titre d'exemples non limitatifs, et représentés aux dessins annexés, dans lesquels:

- la figure 1 est un schéma synoptique du dispositif de contrôle et de mesure de l'isolement selon l'invention;
- la figure 2 montre la représentation vectorielle du courant traversant l'impédance d'isolement;
- les figures 3A à 3G illustrent les signaux électriques en différents points du schéma de la figure 1;
- la figure 4 est une variante du dispositif de la figure 1.

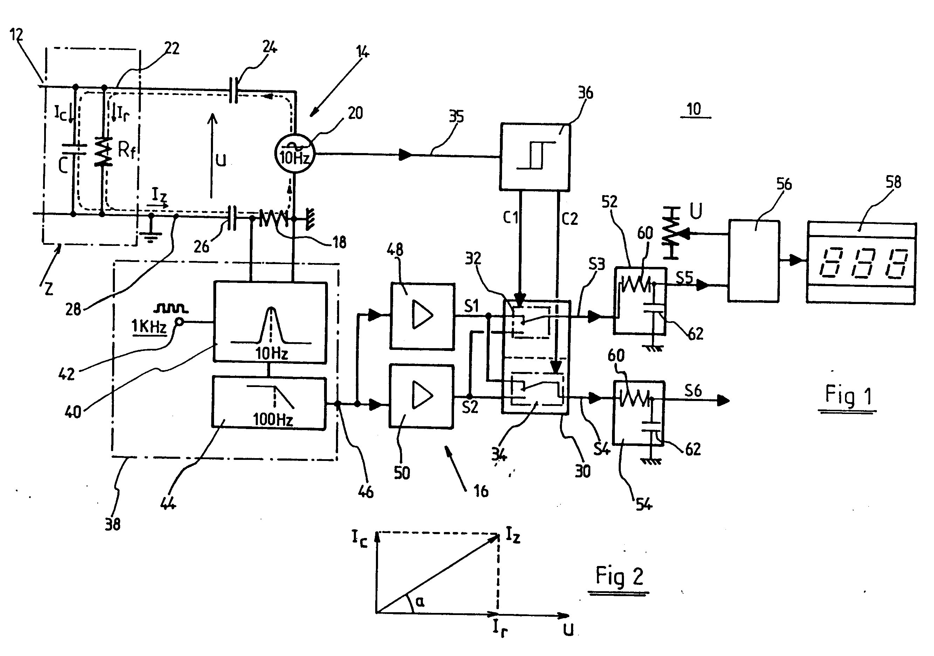

Sur les figures 1 à 3, le dispositif de contrôle 10 de l'isolement d'un réseau électrique 12 alternatif ou continu comporte un circuit d'injection 14 d'un signal alternatif à basse fréquence, et un circuit électronique de détection 16 du courant de fuite IZ traversant une résistance de mesure 18. Le régime de neutre du réseau 12 est du type IT à neutre isolé, la masse de l'installation électrique étant relié à la terre. Le circuit d'injection 14 comprend un générateur 20 susceptible d'appliquer au réseau une tension d'essai alternative u de fréquence 10 Hz (voir figure 3A). Le réseau alternatif 12 pourrait bien entendu comporter plusieurs conducteurs (triphasé avec ou sans neutre). Le réseau 12 pourrait également être constitué par un réseau continu.

L'impédance d'isolement Z est formée par une résistance Rf de fuite connectée électriquement en parallèle sur un condensateur C parasite dont la capacité dépend des caractéristiques du réseau 12, notamment de la longueur du conducteur 22 de phase. La fréquence du réseau 12 alternatif peut être du 50 Hz, 60 Hz, ou 400 Hz et il est impératif que la fréquence de la tension d'essai u du générateur 20 soit inférieure à la fréquence du réseau 12. L'utilisation d'une fréquence basse pour la tension d'essai u permet de visualiser en bout de chaîne des déphasages très faibles de l'ordre du degré, et de minimiser l'intensité du courant IC circulant dans la capacité parasite C.

Dans le cas d'un réseau 12 continu, l'une des bornes du générateur 20 est connectée au conducteur 12 par l'intermédiaire d'un premier condensateur 24 de liaison. La borne opposée du générateur 20 est reliée à la masse du dispositif 10, et à l'une des bornes de la résistance de mesure 18. Un deuxième condensateur 26 de liaison est inséré entre la résistance de mesure 18, et un conducteur 28 connecté électriquement à la terre. Le circuit d'injection 14 forme une boucle fermée dans laquelle la résistance de mesure 18 est branchée en série avec l'impédance d'isolement Z. La tension aux bornes de la résistance de mesure 18 constitue l'image du courant IZ représentant la somme vectorielle des courants IC et IR (figure 2) traversant respectivement le condensateur parasite C et la résistance de fuite Rf.

Dans le cas d'un réseau 12 alternatif, le générateur 20 du circuit d'injection 14 est relié au réseau 12 par un filtre (non représenté). Le principe du circuit électronique de détection 16 consiste à traiter le signal IZ pour faire la discrimination entre les courants partiels IR et IC. Le contrôle d'isolement revient à mesurer l'impédance d'isolement Z, et à en extraire la valeur réelle de la résistance de fuite Rf qui satisfait à la relation (1) suivante:

(1)    $Rf = Z \cos a$,

a, étant le déphasage, entre le courant IZ traversant l'impédance, et la tension u. Il en résulte selon la figure 2,
que le courant IR traversant la résistance de fuite Rf est déterminé par la relation (2):

(2)    $IR = IZ \cos a$,

IR étant en phase avec la tension u de référence aux bornes de l'impédance Z,

et que le courant IC circulant dans le condensateur parasite C est donné par la relation (3):

(3)      IC = IZ sin a,

IC se trouvant en quadrature avec IR.

Pour réaliser la séparation du signal en deux composantes en quadrature selon les relations (2) et (3), le circuit électronique de détection 16 comporte avantageusement un dispositif détecteur synchrone 30, par exemple du type intégré GAT 01 commercialisé par la société Précision Monolithics Incorporated, renfermant deux inverseurs 32,34 statiques identiques, l'un 32 pour traiter le signal IZ cos a concernant le courant IR dans la résistance de fuite Rf, l'autre 34 pour traîter le signal IZ sin a de la relation (3). Les inverseurs 32,34 peuvent également être des composants C MOS ADG 201 A commercialisés par la société Analog Device ADG 201 A.

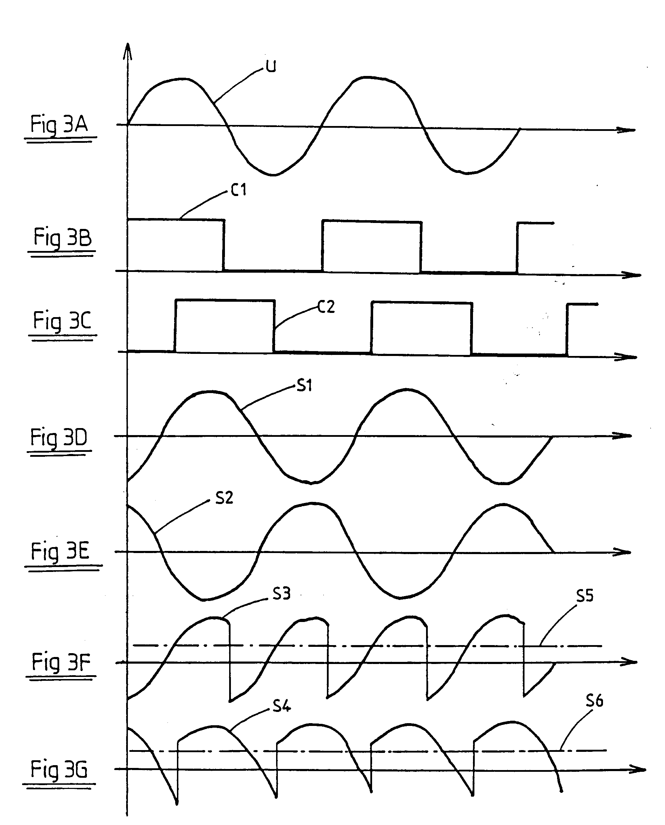

Le générateur 20 est raccordé par une liaison 35 à un convertisseur 36 susceptible de transformer la tension alternative de 10 Hz, en deux signaux carrés C1 et C2 (figures 3 B et 3 C) de mêmes fréquences, destinés à la commande des deux inverseurs 32,34 du détecteur synchrone 30. Le premier signal carré C1 (figure 3B) est en phase avec la tension d'injection u (figure 3A), et pilote l'inverseur 32 de traitement du courant IR servant au calcul de la résistance de fuite Rf. Le deuxième signal carré C2 (figure 3 C) du convertisseur 36 est déphasé de 90 degrés par rapport au signal d'injection u ou au premier signal carré C1, et pilote l'autre inverseur 34 de traitement du courant IC pour le calcul de la capacitance du condensateur C parasite du réseau 12.

La tension présente aux bornes de la résistance de mesure 18 est appliquée à un circuit de filtrage 38 destiné à éliminer les tensions parasites et autres perturbations du réseau 12. Le circuit de filtrage 38 est équipé d'un premier filtre 40 d'entrée susceptible d'autoriser le passage de la tension alternative de fréquence 10 Hz, et ayant une borne 42 additionnelle de commande d'échantillonnage à haute fréquence. La tension à 10 Hz à la sortie du premier filtre 40 se trouve ainsi hachée à une fréquence de 1 kHz. Le hachage est ensuite éliminé par l'action d'un deuxième filtre 44 à 100 Hz, dont la sortie 46 délivre un signal sinusoïdale à la fréquence de 10 Hz propre.

Le signal filtré à 10 Hz issu du circuit de filtrage 38 est injecté dans deux amplificateurs 48,50 agencés pour fournir deux signaux S1 et S2 amplifiés alternatifs en opposition de phase (voir figures 3 D et 3 E), et de même fréquence que la tension injectée u. Les deux signaux S1 et S2 sont appliqués respectivement à un contact repos et à un contact travail de chaque inverseur 32,34, dont le commun est relié électriquement à un circuit intégrateur 52,54 qui extrait la valeur moyenne du signal.

Le signal de sortie S3 et S4 (voir figure 3F et 3G) de chaque inverseur 32,34 est ainsi intégré séparément pour obtenir la valeur moyenne S5 et S6 correspondant respectivement à IZ cos a et IZ sin a. Le signal de sortie S5 de l'intégrateur 52 est ensuite injecté dans un circuit de traitement analogique 56 agencé pour effectuer le rapport entre la valeur de la tension d'injection u et celle du courant IR (c'est à dire IZ cos a) pour déterminer la valeur de la résistance de fuite Rf. La valeur de Rf est visualisée par un afficheur 58, notamment digital à diodes électroluminescentes ou à cristaux liquides ou peut être transmise sur un bus de données (non représenté).

L'autre signal de sortie S6 de l'intégrateur 54 peut également être traité dans un circuit de traitement (non représenté) pour calculer le courant IC et afficher la capacitance du condensateur parasite C. Le déphasage entre les courants IR et IC peut également être déterminé à partir des signaux S5 et S6.

Le fonctionnement du dispositif de contrôle 10 de l'isolement d'un réseau selon les figures 1 et 2 découle de la description précédente, et il suffit de rappeler que le signal S3 élaboré pour le calcul de la résistance de fuite Rf au moyen du détecteur synchrone 30 provient de l'inverseur 32 commandé par le premier signal carré C1 du convertisseur 36, ledit signal étant en phase avec la tension d'injection u. On remarque sur la figure 3D que le signal S1 à la sortie de l'amplificateur 48 se trouve plus ou moins déphasé par rapport au premier signal carré C1 en fonction de la valeur de la capacité du condensateur C parasite.

Le signal S4 pour la détermination de la capacitance du condensateur parasite C de l'impédance de défaut Z, est délivré par l'inverseur 34 piloté par le deuxième signal carré C2 déphasé de 90 degrés par rapport au premier signal C1 du convertisseur 36.

Chaque circuit intégrateur 52,54 peut être formé par un circuit à résistance 60 et condensateur 62 ayant une constante de temps supérieure à 0,1 seconde. La résistance 60 est disposée en série entre la sortie respective de l'inverseur 32,34 et l'entrée du circuit de traitement analogique 56. Le condensateur 62 se trouve connecté en parallèle entre l'entrée du circuit 56 et la masse.

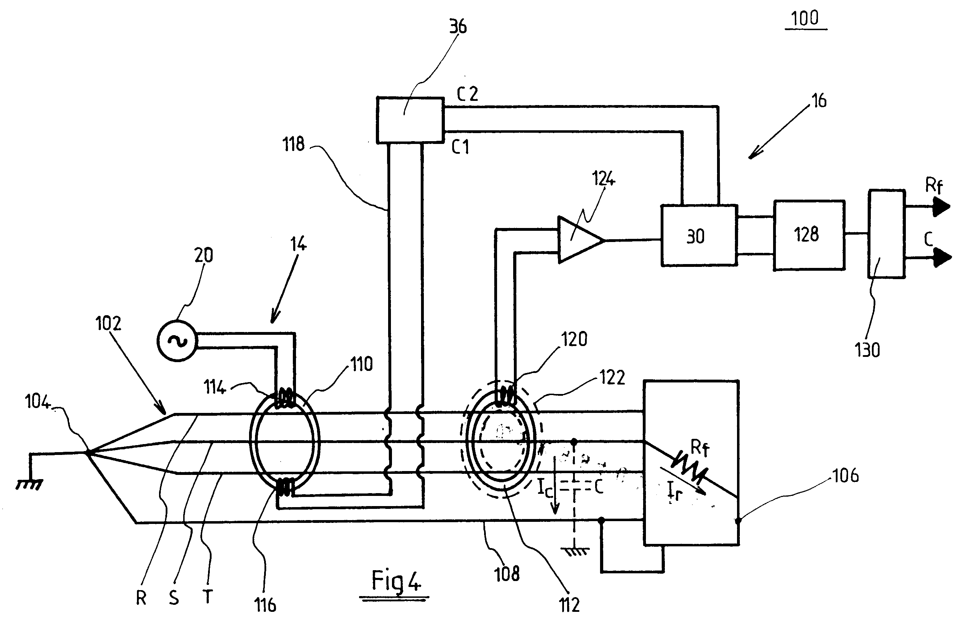

Selon la deuxième mode de réalisation de la figure 4, les mêmes numéros de repères seront utilisés pour désigner des éléments identiques à ceux du dispositif des figures 1 à 3. Le dispositif de contrôle 100 d'isolement est appliqué dans ce cas à un réseau 102 triphasé à régime de neutre TN, dans lequel le point neutre 104 est mis à la terre, et la masse 106 de l'installation éléctrique est reliée au potentiel du conducteur de neutre 108. Le rôle du dispositif de contrôle 100 consiste à injecter un courant de référence dans le réseau 102 à surveiller, et à recueillir un signal de sortie significatif de l'état d'isolement de ce réseau.

Ces deux opérations s'effectue sans déconnexion des conducteurs du réseau 102 au moyen d'un système à deux circuits magnétiques en forme de tores 110, 112. Le premier tore 110 d'excitation fait partie du circuit d'injection 14, et entoure les trois conducteurs de phase R, S, T du réseau 102 triphasé. Le générateur 20 à tension alternative de fréquence 10 Hz est connecté à un enroulement primaire 114 bobiné sur le premier tore 110, lequel constitue un transformateur de tension destiné à créer une différence de potentiel de fréquence 10 Hz dans le réseau 102. Afin de se prémunir contre les déphasages parasites résultant notamment des pertes dans le matériau constitutif du premier tore 110, celui-ci est équipé d'un enroulement auxiliaire 116 susceptible de fournir la tension de référence qui est en phase avec la tension réellement injectée dans le réseau. Cette référence de phase aux bornes de l'enroulement auxiliaire 116 est envoyée dans le convertisseur 36 par la liaison 118. Selon une variante, la tension de référence peut être prélevée directement aux bornes du générateur 20.

Le deuxième tore 112 de mesure fait partie du circuit de détection 16, et entoure également les conducteurs de phase R, S, T en agissant comme un transformateur de courant. Un enroulement secondaire 120 est bobiné à cet effet sur le deuxième tore 112, et fournit un signal dont l'amplitude et la phase représentent l'image de l'impédance d'isolement Z du réseau. La sensibilité de ce deuxième tore 112 est très grande, et un blindage 122 peut entourer le tore 112 pour se prémunir des parasites et des champs magnétiques extérieurs.

Le signal de mesure aux bornes de l'enroulement secondaire 120 du deuxième tore 112 est traité par le détecteur synchrone 30 après amplification dans un amplificateur sélectif 124. Le fonctionnement du détecteur synchrone 30 est identique à celui du dispositif des figures 1 à 3, et est piloté par les deux signaux carrés C1,C2 en quadrature issus du convertisseur 36. Le détecteur synchrone 30 est associé à un circuit de calcul 128 des composantes réelles et imaginaires du signal de mesure, représentant la valeur de la résistance de fuite Rf et de la capacitance du condensateur C parasite du réseau. Ces valeurs sont ensuite visualisées dans un afficheur 130, ainsi que le déphasage entre les courants IR et IC.

Le dispositif de contrôle 100 de l'isolement selon la figure 4 peut bien entendu être utilisé dans un réseau alternatif multipolaire ayant un régime de neutre TT dans lequel le point neutre 104 est relié à la terre, et la masse 106 de l'installation électrique est connectée directement à la terre, ou à un conducteur de terre.

## Revendications

1. Dispositif de contrôle et de mesure de l'isolement d'un réseau électrique par rapport à la terre, comprenant un circuit d'injection (14) d'un signal alternatif de référence dans le réseau (12,102) à surveiller, et un circuit électronique de détection (16) destiné à fournir un signal de mesure significatif de l'état d'isolement du réseau en réponse à l'émission du signal de référence, ledit signal de mesure étant proportionnel à l'impédance d'isolement Z formée par une résistance de fuite Rf, et un condensateur C parasite dont la capacité dépend des caractéristiques du réseau (12,102), le circuit de détection (16) comportant des moyens de discrimination des composantes dudit signal de mesure, ayant une première composante fonction du courant IR traversant la résistance de fuite Rf, et une deuxième composante fonction du courant IC circulant dans le condensateur C parasite, la fréquence du signal alternatif de référence injecté dans le réseau (12,102) étant inférieure à la fréquence du réseau caractérisé en ce que:
   - les moyens de discrimination du circuit de détection (16) comportent un dispositif détecteur synchrone (30) ayant une paire d'inverseurs (32,34) statiques de traitement des première et deuxième composantes du signal de mesure, et un convertisseur (36) destiné à délivrer deux signaux C1 et C2 en quadrature pour la commande respective des inverseurs (32,34), le premier signal de commande C1 étant en phase avec le signal alternatif de référence injecté dans le réseau (12,102) par le circuit d'injection (14),
   - le signal de mesure proportionnel à l'impédance d'isolement Z est appliqué à un circuit de filtrage (38) destiné à délivrer un signal filtré à la fréquence du signal alternatif de référence,
   - un circuit amplificateur (48,50,124) coopère avec le circuit de filtrage (38) pour fournir deux signaux amplifiés S1 et S2 en opposition de phase, appliqués respectivement à un contact repos et à un contact travail de chaque inverseur (32,34),
   - un circuit intégrateur (52,54) est connecté à la sortie de chaque inverseur (32,34) pour extraire la valeur moyenne des première et deuxième composantes du signal de mesure,

- et des moyens de calcul et d'affichage sont connectés à la sortie de chaque circuit intégrateur (52,54) pour indiquer les valeurs de la résistance de fuite (Rf) et de la capacité du condensateur C parasite.

2. Dispositif de contrôle et de mesure de l'isolement selon la revendication 1, appliqué à un réseau alternatif à neutre isolé, ayant notamment un régime de neutre du type IT, caractérisé en ce que le signal alternatif de référence est injecté dans le réseau (12) au moyen d'un générateur (20) par l'intermédiaire de condensateurs (24,26) de liaison, et que le signal de mesure est prélevé aux bornes d'une résistance de mesure (18) insérée en série avec le générateur (20) et l'impédance d'isolement Z.

3. Dispositif de contrôle et de mesure de l'isolement selon la revendication 2 caractérisé en ce que le circuit de filtrage (38) du signal de mesure comporte un premier filtre (40), d'entrée ayant une borne (42) additionnelle de commande d'échantillonnage à haute fréquence, destinée à hacher la tension filtrée de sortie du premier filtre (40) et un deuxième filtre (44) susceptible d'éliminer le hachage engendré dans le premier filtre (40), de manière à délivrer un signal alternatif de mesure, filtré à la fréquence du signal de référence émis par le générateur (20).

4. Dispositif de contrôle et de mesure de l'isolement selon la revendication 1, appliqué à un réseau alternatif à régime de neutre TT ou TN, caractérisé en ce que le signal alternatif de référence est injecté dans le réseau (102) au moyen d'un premier tore (110) d'excitation entourant les conducteurs R, S, T de phase du réseau et ayant un enroulement primaire 114 raccordé à un générateur (20), et que le signal de mesure représentant l'image de l'impédance d'isolement Z du réseau (102) est prélevé aux bornes d'un enroulement secondaire (120) bobiné sur un deuxième tore (112) de mesure entourant les mêmes conducteurs du réseau.

5. Dispositif de contrôle et de mesure de l'isolement selon la revendication 4, caractérisé en ce que le premier tore (110) est équipé d'un enroulement auxiliaire (116) susceptible de fournir au convertisseur (36) une référence de phase correspondant au signal réellement injecté dans le réseau par le circuit d'injection (14) à tore (110).

**Claims**

1. A monitoring and measuring device of the insulation of an electrical network with respect to earth, comprising an input circuit (14) of a reference AC signal to the network (12, 102) to be monitored, and an electronic detection circuit (16) designed to supply a measurement signal significant of the insulation status of the network in reply to the sending of the reference signal, said measurement signal being proportional to the ground fault impedance Z formed by a leakage resistor Rf, and a stray capacitor C whose capacitance depends on the characteristics of the electrical network (12, 102), the detection circuit (16) comprising means for discriminating the components of said measurement signal, having a first component being a function of the current IR flowing through the leakage resistance Rf, and a second component being a function of the current IC flowing through the stray capacitor C, the frequency of the reference AC signal input to the network (12, 102) being lower than the frequency of the network, characterized in that :

   - the discrimination means of the detection circuit (16) comprise a synchronous detection device (30) having a pair of static inverters (32, 34) for processing of the first and second components of the measurement signal, and a converter (36) designed to deliver two quadrature signals C1 and C2 to respectively control the two inverters (32, 34), the first control signal C1 being in phase with the reference AC signal input to the electrical network (12, 102) by the input circuit (14),

   - the measurement signal proportional to the ground fault impedance Z is applied to a filtering circuit (38) designed to deliver a filtered signal at the frequency of the reference AC signal,

   - an amplifier circuit (48, 50, 124) cooperates with the filtering circuit (38) to supply two amplified signals S1 and S2 of opposite phase, applied respectively to a break contact and a make contact of each inverter (32, 34),

   - an integrating circuit (52, 54) is connected to the output of each inverter (32, 34) to extract the mean value of the first and second components of the measurement signal,

   - and computation and display means are connected to the output of each integrating circuit (52, 54) to indicate the values of the leakage resistances (Rf) and of the capacitance of the stray capacitor C.

2. The insulation monitoring and measuring device according to claim 1, applied to an electrical network with isolated neutral, having notably an IT type neutral system, characterized in that the reference AC signal is input to the network (12) by means of a generator (20) via connecting capacitors (24, 26), and that the measurement signal is taken at the terminals of a measuring resistance (18) inserted in series with the generator (20) and ground fault impedance Z.

3. The insulation monitoring and measuring device according to claim 2, characterized in that the measurement signal filtering circuit (38) comprises a first input filter (40) having an additional high-frequency sampling control terminal (42), designed to chop the filtered voltage output from the first filter (40) and a second filter (44) capable of eliminating the chopping generated in the first filter (40), so as to deliver a measurement AC signal, filtered at the frequency of the reference signal emitted by the generator (20).

4. The insulation monitoring and measuring device according to claim 1, applied to an AC network with TT or TN neutral, characterized in that the reference AC signal is input to the network (102) by means of a first excitation toroid (110) surrounding the phase conductors R, S, T of the network and having a primary winding (114) connected to a generator (20), and that the measurement signal representing the image of the ground fault impedance Z of the network (102) is taken at the terminals of a secondary winding (120) wound on a second measuring toroid (112) surrounding the same network conductors.

5. The insulation monitoring and measuring device according to claim 4, characterized in that the first toroid (110) is equipped with an auxiliary winding (116) capable of supplying the converter (36) with a phase reference corresponding to the signal actually input to the network by the input circuit (14) with toroid (110).

**Patentansprüche**

1. Schaltungsanordnung zur Überwachung und Messung des Isolationswiderstands eines elektrischen Netzes gegen Erde, bestehend aus einem Treiberkreis (14), der dem zu überwachenden Netz (12, 102) ein Wechselspannungs-Referenzsignal zuführt, und einer elektronischen Auswerteschaltung (16), die dazu dient, in Abhängigkeit vom zugeführten Referenzsignal ein Meßsignal zu liefern, das den Isolationszustand des Netzes abbildet, wobei das genannte Meßsignal der Isolationsimpedanz Z, gebildet aus einem Ableitwiderstand Rf und einem Störkondensator C, dessen Kapazität von den Parametern des Netzes (12, 102) abhängt, proportional ist, die Auswerteschaltung (16) Mittel zu Erfassung der Anteile des genannten Meßsignals aufweist, das sich aus einem ersten Anteil in Abhängigkeit vom durch den Ableitwiderstand Rf fließenden Strom IR und einem zweiten Anteil in Abhängigkeit vom durch den Störkondensator C fließenden Strom IC zusammensetzt, und die Frequenz des dem Netz (12, 102) zugeführten Wechselspannungs-Referenzsignals unterhalb der Netzfrequenz liegt, dadurch gekennzeichnet, daß:

- die Mittel zur Meßsignalerfassung der Auswerteschaltung (16) ein Synchron-Meßglied (30) mit zwei elektronischen Umschaltern (32, 34) zur Verarbeitung des ersten und des zweiten Anteils des Meßsignals sowie einen Stromrichter (36) zur Bereitstellung von zwei um 90 Grad phasenverschobenen Signalen C1 und C2 zur Ansteuerung der zugeordneten elektronischen Umschalter (32, 34) umfassen, wobei das erste Signal zur Ansteuerung von C1 die gleiche Phasenlage aufweist wie das dem Netz (12, 102) über den Treiberkreis (14) zugeführte Wechselspannungs-Referenzsignal,

- das der Isolationsimpedanz Z proportionale Meßsignal einer Filterschaltung (38) zugeführt wird, die dazu dient, ein gefiltertes Signal zu liefern, dessen Frequenz mit der des Wechselspannungs-Referenzsignalsignals übereinstimmt,

- eine Verstärkerschaltung (48, 50, 124) mit der Filterschaltung (38) zusammenwirkt, um zwei verstärkte gegenphasige Signale S1 und S2 zu erzeugen, die einem Ruhe- bzw. einem Arbeitskontakt jedes elektronischen Umschalter (32, 34) zugeführt werden,

- eine Integratorschaltung (52, 54) mit dem Ausgang jedes elektronischen Umschalters (32, 34) verbunden ist, um den Mittelwert des ersten und des zweiten Anteils des Meßsignals zu bilden

- und Rechen- und Anzeigemittel an den Ausgang jeder Integratorschaltung (52, 54) angeschlossen sind, um die Werte für den Ableitwiderstand Rf sowie für die Kapazität des Störkondensators C anzuzeigen.

2. Schaltungsanordnung zur Überwachung und Messung des Isolationswiderstands nach Anspruch 1, eingesetzt in einem Wechselspannungsnetz mit isoliertem Neutralleiter, insbesondere in einem IT-Netz, dadurch gekennzeichnet, daß dem Netz (12) das Wechselspannungs-Referenzsignal mit Hilfe eines Wechselspannungsgenerators (20) über Ankopplungskondensatoren (24, 26) zugeführt wird und das Meßsignal an den Klemmen eines in Reihe zwischen dem Wechselspannungsgenerator (20) und der Isolationsimpedanz Z geschalteten Meßwiderstands (18) abgegriffen wird.

3. Schaltungsanordnung zur Überwachung und Messung des Isolationswiderstands nach Anspruch 2, dadurch gekennzeichnet, daß die Meßsignal-Filterschaltung (38) ein erstes Eingangsfilter (40) mit einer zusätzlichen Steuerklemme (42) zur Hochfrequenz-Abtastung aufweist, die dazu dient, die gefilterte Ausgangsspannung des ersten Filters (40) zu zerhacken, und mit einem zweiten Filter (44) bestückt ist, um die durch das erste Filter (40) durchgeführte Zerhackung aufzuheben, so daß ein gefiltertes Wechselspannungs-Meßsignal geliefert wird, das die gleiche Frequenz aufweist wie das vom Wechselspannungsgenerator (20) bereitgestellte Referenzsignal.

4. Schaltungsanordnung zur Überwachung und Messung des Isolationswiderstands nach Anspruch 1, eingesetzt in einem Wechselspannungsnetz mit TT- oder TN-Netzform, dadurch gekennzeichnet, daß das Wechselspannungs-Referenzsignal dem Netz (102) über einen ersten Wandlerkern (110) zugeführt wird, der um die Phasenleiter R, S, T gelegt ist und eine mit einem Generator (20) verbundene Primärwicklung (114) aufweist, und das die Isolationsimpedanz Z des Netzes (102) abbildende Meßsignal an den Klemmen einer um einen zweiten Wandlerkern (112) gewickelten Sekundärwicklung (120) abgegriffen wird, die die gleichen Netzleiter umgibt.

5. Schaltungsanordnung zur Überwachung und Messung des Isolationswiderstands nach Anspruch 4, dadurch gekennzeichnet, daß der erste Wandlerkern (110) mit einer Hilfswicklung (116) versehen ist, die dem Stromrichter (36) einen Phasenbezugswert entsprechend dem durch den Treiberkreis (14) mit Wandlerkern (110) tatsächlich in das Netz eingebrachten Signal liefert.

Fig 3A

Fig 3B

Fig 3C

Fig 3D

Fig 3E

Fig 3F

Fig 3G

Fig 4

EP 0 297 933 B1